# EUROPEAN PATENT APPLICATION

(11) **EP 4 804 342 A1**
(43) Date of publication of application: **09.09.2026**
(21) Application number: 26154777.2
(22) Date of filing: 28.01.2026
(51) Int. Cl.: H01R 13/518, H01R 43/18, H05K 1/02, B29C 45/00, H01R 13/66, G01D 11/24, H01R 13/514

(54) **ELECTRONICS ON INNER HOUSING SURFACE OF CONNECTOR**

(30) Priority: 03.03.2025 GB 202503000
(71) Applicant: Harting International Innovation AG, 2504 Biel (CH)
(72) Inventor: Hagen, Simon, 2504 Biel (CH)

(57) **Abstract**

The invention relates to a housing (1) for an industrial connector, wherein the housing comprises an inner surface (5); a non-conductive coating applied on the inner surface (5); and a molded interconnect device (MID) integrated on the coating. The housing (1) is designed to enhance the integration of electronic components. The molded interconnect device (MID) may carry a central processing unit (3) and includes circuit paths (2). The invention further relates to a industrial connector, a method for manufacturing the housing (1) and a method for retrofitting an existing housing (1).

## Description

### FIELD OF THE INVENTION

The present invention relates to housings for modular industrial connectors, specifically those designed to enhance the integration of electronic components while maintaining compactness and efficiency, including options for retrofitting existing systems.

### BACKGROUND OF THE INVENTION

Modular industrial connectors are essential for ensuring reliable connections in various electronic and electrical applications. Traditionally, the housings of such connectors are manufactured from conductive materials, such as metals, primarily to enhance structural stability and durability. However, using metal can complicate the integration of electronic components directly onto the housing, as it can lead to electrical interference and is not conducive to embedding electronic circuits.

### PRIOR ART

From prior art, modular connector systems are known that often rely on printed circuit boards (PCBs) to integrate sensors and evaluation electronics. These systems require additional components like mounting frames, which can restrict miniaturization efforts and complicate retrofitting into existing designs. A major drawback is the dependency on separate modules and frames, leading to inefficient use of space within the connector assembly.

Furthermore, in prior art, Molded Interconnect Devices (MID) are known. MIDs are components that combine mechanical and electrical functions into a single part. By integrating conductive pathways directly onto plastic substrates, MIDs enable the miniaturization and functional enhancement of electronic systems. They are typically manufactured using injection molding processes with thermoplastic or high-performance plastics that are optimized for subsequent structuring and metallization.

A key manufacturing method is Laser Direct Structuring (LDS), where a laser precisely structures the surface of the plastic and prepares it for selective metallization. In subsequent steps, conductive layers, such as copper, nickel, or gold, are applied to create electrical connections and functionalities.

The MID technology offers numerous advantages, including reduced size and weight, increased design flexibility through three-dimensional structures, a lower number of individual components, and the seamless integration of electronic and mechanical functions into a single part. These features make MIDs a key technology for applications in the automotive industry, medical devices, telecommunications, and wearable electronics.

### TASK

Given the limitations mentioned above, there is a need for a more integrated approach that allows electronic components to be incorporated directly into the housing of the modular industrial connector, minimizing the space required and enhancing flexibility in design. This invention addresses the need for efficient integration of electronics without altering the external dimensions or primary functionality of the connector, while also providing opportunities for retrofitting existing systems.

This is achieved by a housing, a industrial connector, a method for manufacturing a housing and a method for retrofitting an existing housing or an existing industrial connector according to the independent claims. Further developments are given in the dependent claims.

### SUMMARY OF THE INVENTION

According to the invention, a housing for a industrial connector comprises an inner surface, a non-conductive coating applied on the inner surface, and a molded interconnect device integrated on the coating. The molded interconnect device can be integrated directly on the coating. This allows the moulded interconnect device to be applied directly to the coated inner surface of the package without the need for a separate substrate or assembly carrier.

Preferably, the industrial connector is a modular industrial connector.

This configuration provides a compact and efficient solution for integrating electronic components directly into the housing, enabling the reduction of additional space requirements typically associated with separate circuit boards or assembly carriers. By integrating the moulded interconnect device directly onto the coated inner surface, additional mounting structures or substrates are avoided. It enhances the overall design flexibility and allows for streamlined manufacturing processes, reducing production costs and improving the performance reliability of the connector assembly. Furthermore, it allows for integration on housings made from metallic, conductive materials by isolating the electronics from the conductive surfaces, thus expanding the range of materials that can be used in connector housing construction.

According to a preferred embodiment of the invention, the molded interconnect device comprises at least one circuit path configured to connect electronic or electrical components.

This feature supports the seamless connection of various electronic components within the housing, ensuring efficient electrical connectivity without the need for additional wiring or external circuit boards. It simplifies the design and assembly process, leading to more reliable and compact connector assemblies.

According to a preferred embodiment of the invention, the molded interconnect device further comprises electronic or electrical components such as a central processing unit, a network interface such as an antenna, an RF component, and/or a connection point for a wireless or wired connection, sensors such as a temperature sensor, an electrical filter circuit, an actuator, and/or a power supply.

This embodiment enhances the functionality of the connector by integrating critical electronic components directly onto the molded interconnect device. It allows for advanced data processing, communication capabilities, sensing, and power management within the housing, making the connector more versatile and capable of supporting complex industrial applications.

According to a preferred embodiment of the invention, the molded interconnect device integrates data lines for transmitting data within a system, as part of a bus system such as CAN-Bus, I²C, SPI or an Ethernet-based network.

This integration supports efficient data management and communication within electronic systems. By embedding data lines within the molded interconnect device, the invention ensures faster data transmission rates and reduces latency. It also facilitates robust and reliable data exchange, critical for applications requiring high-speed and secure data communication within the connector itself, but also with external devices that are all part of the same network (e.g. for streaming sensor data). Additionally, when the connector is part of a bus or network, it can implicitly become a participant in that network, capable of communicating with external devices to transmit collected sensor data or access the Internet provided by a network participant.

According to the invention, an industrial connector, preferably a modular industrial connector, is claimed. Said connector comprises a housing that further comprises a mounting frame configured to hold at least one module or one insert of a connector system.

This feature provides a standardized and secure method for mounting various modules within the housing. It enhances the modularity and flexibility of the connector system, allowing for easy customization and expansion based on specific application requirements.

Here, preferably, the insert may be a contact insert. Frame, module(s), and contact insert(s) may preferably be parts of the connector and not of the housing.

According to a preferred embodiment of the invention, the mounting frame is configured to connect said at least one module or one insert with the molded interconnect device.

This configuration ensures that the modules and inserts are not only physically secured within the housing but also electrically connected to the molded interconnect device. It provides a robust and integrated solution for connecting multiple modules, simplifying the overall system architecture.

According to a preferred embodiment of the invention, a industrial connector, preferably a modular industrial connector, with a housing as described is configured such that the at least one module or one insert is connected to the electronic or electrical components of the molded interconnect device (MID) via the mounting frame, and the mounting frame ensures physical connection as well as information-technical connection.

This embodiment ensures that the modules are securely connected both physically and electrically, providing a comprehensive solution for integrating various functionalities within the connector. It enhances the robustness and reliability of the connector system, making it suitable for demanding industrial environments.

According to the invention, a method for manufacturing a housing for a modular industrial connector comprises the steps of providing a housing with an inner surface, applying a non-conductive coating to the inner surface, and integrating a molded interconnect device on the coating.

This method facilitates the efficient production of advanced connector assemblies with integrated electronics. It streamlines the manufacturing workflow, reducing errors and improving consistency. The approach also enables scalability, allowing manufacturers to easily adapt to varying production demands without compromising quality.

According to the invention, a method for retrofitting an existing housing or an existing modular industrial connector comprises the steps of applying a non-conductive coating to the inner surface and integrating a molded interconnect device on the coating.

This retrofitting method enables upgrades to existing systems, enhancing their capabilities without the need for complete replacement. It offers a cost-effective solution for extending the lifespan and functionality of current installations. The method supports sustainable practices by minimizing waste and leveraging existing infrastructure, making it an environmentally friendly option for modernizing technology systems.

The invention can be better understood with reference to the following drawing and description. The components in the figure are not necessarily to scale, emphasis instead being placed upon illustrating various preferred embodiments of the invention.

### The Figure depicts:

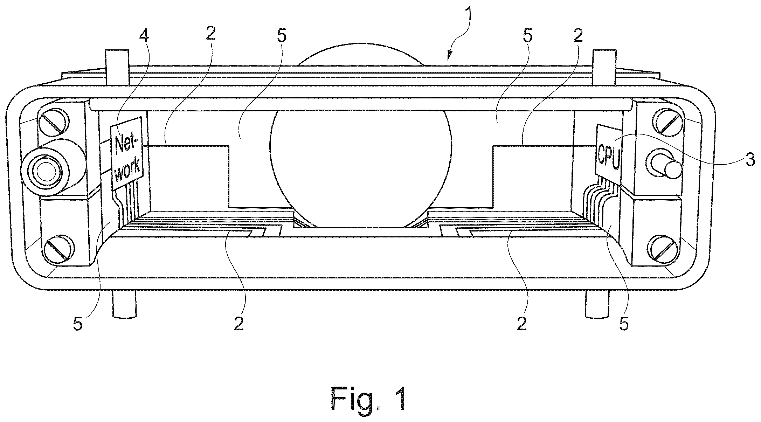

- Figure 1: shows an example for a housing for a modular industrial connector, showing the integration of electronic components and circuit paths on the inner surface.

**Fig. 1** illustrates a housing 1 for a modular industrial connector, designed to integrate electronic components directly onto its inner surface 5. The package 1 is shown with an internal view, showing how the moulded interconnect device (also known as MID) is integrated directly onto a non-conductive coating applied to the internal surface 5, without the need for a separate substrate or assembly carrier. This configuration allows for the placement of circuit paths 2, which connect various electronic components.

The central processing unit 3 (also names as CPU 3) is one of the key components mounted on the MID. The CPU 3 is connected via the circuit paths 2 to other components, facilitating data processing and control within the connector assembly. Network interfaces 4, such as antennas and RF components, are also integrated, enabling the housing 1 to support various communication protocols, including wireless and wired connections. This feature enhances the connectivity capabilities of the industrial connector, making it versatile for different applications.

Additionally, the MID can house various sensors, such as temperature sensors, which allow the connector assembly to monitor environmental conditions. Electrical filter circuits can also be integrated into the MID to improve signal quality and reduce noise, ensuring reliable data transmission. Actuators and power supplies can be included to provide control functions and power management within the connector assembly.

The design ensures that the electronic components are isolated from the conductive metal housing, allowing for improved performance and reduced interference. By applying the moulded interconnect directly to the non-conductive coating on the inner surface of the package, no separate substrate or assembly carrier is required, contributing to a more compact and integrated design. This setup not only supports efficient data management but also allows for retrofitting existing connector assemblies by applying the non-conductive coating and integrating the MID.

In further embodiments, the housing 1 can incorporate additional features such as advanced data lines for high-speed communication, supporting systems like CAN-Bus, I²C, or SPI or Ethernet-based networks. These enhancements enable the housing to function as a sophisticated hub for electronic and communication applications, providing versatility and adaptability across different use cases.

The housing 1 also includes a mounting frame configured to hold modules of a modular connector system. This mounting frame ensures that the modules are securely held in place and connected to the MID, both physically and electrically. This facilitates the integration of multiple functionalities within the connector assembly, enhancing its modularity and flexibility.

In some embodiments, the mounting frame may include contact points, such as contact fingers or spring contacts, configured to provide an electrical connection between the at least one module or insert and the circuit paths 2 of the moulded interconnect device. These contact points provide a reliable and direct electrical interface to ensure that signals and power can be efficiently transferred between the modules and the integrated electronics on the inner surface 5 of the housing 1.

A modular industrial connector, comprising the housing 1 as described, benefits from the integrated and modular design, offering enhanced performance, reliability, and flexibility. The connector is well-suited for industrial applications where robust and adaptable connectors are essential.

The invention's ability to integrate electronics directly onto the housing 1 offers significant advantages, including space savings, increased reliability, and the potential for miniaturization. This approach supports modern design requirements and paves the way for innovative applications in electronic systems. The retrofitting method enables upgrades to existing systems, enhancing their capabilities without the need for complete replacement. It offers a cost-effective solution for extending the lifespan and functionality of current installations. The method supports sustainable practices by minimizing waste and leveraging existing infrastructure, making it an environmentally friendly option for modernizing technology systems.

### Reference Numbers

- 1: Housing
- 2: Circuit paths
- 3: Central processing unit / CPU
- 4: Network interfaces
- 5: Inner surface
- MID: molded interconnect device

## Claims

1. A housing (1) for an industrial connector, preferably a modular industrial connector, comprising:
an inner surface (5);
a non-conductive coating applied on the inner surface (5); and
a molded interconnect device (MID) integrated on the coating.

2. The housing (1) according to claim 1, wherein
the molded interconnect device (MID) comprises at least one circuit path (2) configured to connect electronic or electrical components.

3. The housing (1) according to claim 1 or 2, wherein
the molded interconnect device (MID) further comprises electronic or electrical components such as
- a central processing unit (3),
- a network interface (4) such as an antenna, a RF component, and/or a connection point for a wireless or wired connection,
- a sensors such as a temperature sensor,
- an electrical filter circuit,
- an actuator, and/or
- a power supply.

4. The housing (1) according to any of claims 1 to 3, wherein the molded interconnect device (MID) integrates data lines for transmitting data within a system, as part of a bus system such as CAN-Bus, I²C, SPI or an Ethernet-based network.

5. An industrial connector, preferably a modular industrial connector, comprising:
a housing (1) according to any of claims 1 to 4 and a mounting frame configured to hold at least one module or one insert of a connector system.

6. The industrial connector according to claim 5, wherein the mounting frame is configured to connect said at least one module or one insert with the molded interconnect device (MID).

7. The industrial connector according to claim 6, wherein the at least one module or one insert is connected to the electronic or electrical components of the molded interconnect device (MID) via the mounting frame, wherein the mounting frame ensures physical connection as well as information-technical connection.

8. The industrial connector according to claim 6 or 7, wherein the mounting frame comprises contact points configured to establish electrical connection between the at least one module or insert and the circuit paths (2) of the molded interconnect device (MID).

9. A method for manufacturing a housing (1) according to any of claims 1 to 4 for an industrial connector according to any of claims 5 to 8, comprising the steps of:
- providing the housing (1) with an inner surface (5);
- applying a non-conductive coating to the inner surface (5);
- integrating a molded interconnect device (MID) on the coating.

10. A method for retrofitting an existing housing (1) according to any of claims 1 to 4 or an industrial connector according to claim 5 to 8, comprising the steps of:
- applying a non-conductive coating to the inner surface (5);
- integrating a molded interconnect device (MID) on the coating.
